# FASCICULE DE BREVET EUROPEEN

(11) **EP 2 816 624 B1**
(45) Date de publication et mention de la délivrance du brevet: **15.12.2021**
(21) Numéro de dépôt: 14172883.2
(22) Date de dépôt: 18.06.2014
(51) Int. Cl.: H01L 49/02, H01L 21/768, H01L 23/48, H01L 23/64, H01G 2/10, H01G 4/236, H01G 4/35

(54) **Procédé de réalisation d'une liaison électrique traversante et d'un condensateur traversant dans un substrat**
Verfahren zur Herstellung einer Substratdurchkontaktierung und eines durchgehenden Kondensators in einem Substrat
Method for producing a through substrate via and a through substrate capacitor in a substrate

(30) Priorité: 18.06.2013 FR 1355710
(43) Date de publication de la demande: 24.12.2014
(73) Titulaire: STMicroelectronics (Crolles 2) SAS, 38920 Crolles (FR); COMMISSARIAT À L'ÉNERGIE ATOMIQUE ET AUX ÉNERGIES ALTERNATIVES, 75015 Paris (FR)
(72) Inventeur: Joblot, Sylvain, 38690 Bizonnes (FR); Colonna, Jean-Philippe, 38700 CORENC (FR); Guiller, Olivier, 38700 LE SAPPEY EN CHARTREUSE (FR); Mourier, Thierry, 38240 MEYLAN (FR)
(74) Mandataire: Casalonga

(56) Documents cités:
- FR-A1- 2 968 130
- US-A1- 2006 001 174
- US-A1- 2008 173 993
- US-A1- 2010 308 435
- US-A1- 2011 027 962
- US-A1- 2012 258 589
- JOSHI ET AL: "Low-Cost On-Chip Passive Devices Formed By Through Silicon Vias", IP.COM JOURNAL, IP.COM INC., WEST HENRIETTA, NY, US, 1 février 2011 (2011-02-01), XP013142363, ISSN: 1533-0001
- None

## Description

L'invention concerne les dispositifs semiconducteurs, en particulier les liaisons électriques traversantes, également connues par l'homme du métier sous l'acronyme anglosaxon TSV (« Through Silicone Via ») et les condensateurs réalisés au sein de ces dispositifs.

La demande de brevet français n° 10 59 919, publié sous le numéro FR 2 968 130 A1, décrit une structure semiconductrice comportant une liaison électrique traversante et un condensateur traversant le substrat. Cependant, la connexion électrique du condensateur sur l'une des faces du substrat nécessite de prévoir la formation d'un trou secondaire pour y loger un moyen de connexion électrique. Il en résulte par conséquent une complication du procédé de fabrication.

En outre, le procédé de fabrication décrit dans cette demande de brevet français n'est pas compatible avec des liaisons électriques (TSV) et des condensateurs présentant un même diamètre, et par conséquent une même profondeur lors de la réalisation. Il en résulte par conséquent un risque de cassure du TSV lors de la fabrication.

L'article « Low-Cost On-Chip Passive Devices Formed By Through Silicon Vias » de Joshi et al., IP.COM journal, 1 février 2011, décrit la formation simultanée d'un TSV et d'un condensateur traversant le substrat, ayant des diamètres différents.

Selon un mode de mise en œuvre, il est proposé un procédé permettant une réalisation plus simple de vias traversants et de condensateurs au sein d'un substrat d'une structure intégrée et parfaitement compatible avec des vias traversants et des condensateurs présentant en particulier des diamètres, et par conséquent des profondeurs, identiques.

Selon un aspect, il est proposé un procédé de réalisation d'au moins une liaison électrique traversante et d'au moins un condensateur traversant dans un substrat.

Le procédé selon cet aspect comprend
une formation dans le substrat depuis une première face d'au moins un premier orifice borgne destiné à la formation du condensateur et d'au moins un deuxième orifice borgne destiné à la formation de la liaison électrique traversante,
une formation d'une première région d'électrode dudit condensateur au moins sur les parois latérales et sur la paroi de fond du premier orifice borgne, ladite formation de la première région d'électrode comportant une formation, par exemple par dépôt, d'une couche initiale électriquement conductrice dans le premier orifice borgne par électrolyse à partir d'une première couche de germination électriquement conductrice,
-un remplissage du premier orifice borgne et du deuxième orifice borgne par la formation dans le premier orifice d'un empilement comportant au moins une couche diélectrique et une couche additionnelle électriquement conductrice au dessus de ladite couche diélectrique, la couche additionnelle formant une deuxième région d'électrode dudit condensateur et par la formation dans le deuxième orifice d'un empilement comportant au moins la couche additionnelle pour former au moins une partie de ladite liaison électrique,
un amincissement du substrat à partir d'une deuxième face jusqu'à dévoiler les premier et second orifices borgnes et atteindre la première région d'électrode dans le premier orifice et atteindre ladite couche additionnelle dans le second orifice pour former la liaison électrique traversante, ladite couche initiale électriquement conductrice n'étant pas présente dans le fond du deuxième orifice après ledit amincissement, et
une réalisation d'une première zone électriquement conductrice en contact avec ladite première région d'électrode et d'une deuxième zone électriquement conductrice en contact avec ladite liaison électrique traversante, dans lequel les orifices borgnes ont la même profondeur, et la hauteur de la portion de fond de la première région d'électrode est supérieure à la distance séparant la paroi de fond du deuxième orifice borgne de ladite couche additionnelle contenue dans ce deuxième orifice borgne,
ces deux zones pouvant faire partie par exemple d'une couche de redistribution (RDL : ReDistribution Layer).

Selon un mode de mise en œuvre, la couche additionnelle électriquement conductrice présente dans le premier orifice et la couche additionnelle électriquement conductrice présente dans le deuxième orifice sont obtenues par la formation, par exemple par dépôt, d'une même couche globale électriquement conductrice.

Selon un mode mise en œuvre, l'amincissement du substrat comprend une formation d'une face plane sur laquelle débouchent à la fois au moins une partie de ladite couche additionnelle située dans le premier orifice borgne et une partie de la portion de fond de la première région d'électrode, et la première zone électriquement conductrice en contact avec ladite première région d'électrode et la deuxième zone électriquement conductrice en contact avec ladite liaison électrique traversante sont réalisées au dessus de ladite face plane.

Ainsi, le fait que les deux faces de contact de la première région d'électrode d'une part, et de la liaison électrique d'autre part, avec la couche de redistribution, soient situées dans un même plan, simplifie le procédé de réalisation et évite notamment la formation d'un trou secondaire de l'art antérieur.

Le procédé peut également comporter en outre une formation au dessus de ladite première face d'une partie d'interconnexion de circuit intégré en contact avec lesdites couches additionnelles du premier et du second orifice.

Là encore, ceci permet d'avoir les deux faces de contact de l'électrode du condensateur d'une part, et de la liaison électrique d'autre part, dans un même plan lors du traitement de rabotage.

Lorsque les deux orifices borgnes ont le même diamètre, le procédé peut comprendre un dépôt de la première couche de germination dans chacun des orifices borgnes et également au dessus de la première face du substrat, et une gravure de cette première couche de germination dans une zone située au dessus de la première face du substrat entre les orifices borgnes, et ce, de façon à éviter un remplissage du deuxième orifice borgne lors de l'opération d'électrolyse.

Selon un mode de mise en œuvre, le comblement des orifices borgnes comprend une formation dudit empilement de couches également au dessus de la première face du substrat et un retrait de la partie dudit empilement de couches au dessus de la première face du substrat et un retrait de la partie dudit empilement de couches située au dessus de la première face du substrat à l'extérieur des orifices borgnes.

D'autres avantages et caractéristiques de l'invention apparaîtront à l'examen de la description détaillée de modes de mise en œuvre et de réalisation, nullement limitatifs, et des dessins annexés, sur lesquels :
- les figures 1 à 13 ont trait à différents modes de mise en œuvre et de réalisation du procédé selon l'invention.
- les figures 14 à 18 ont trait à un exemple ne faisant pas partie de la présente invention.

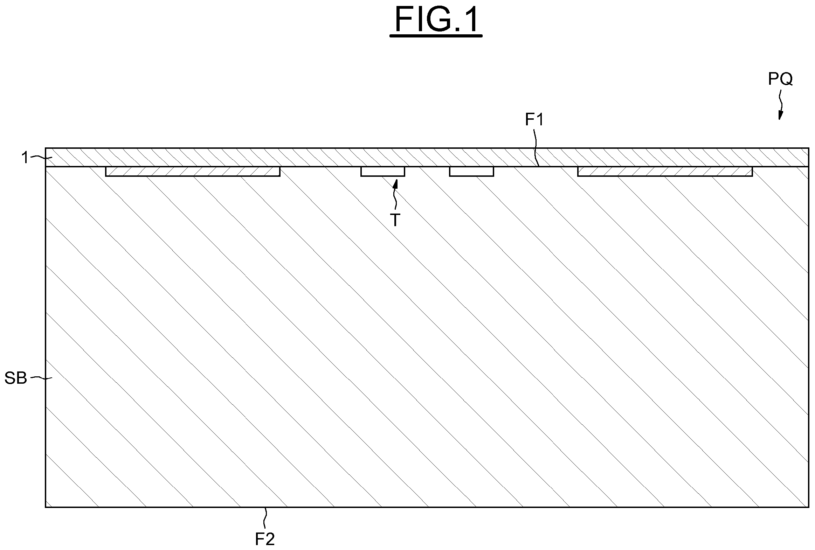

On se réfère maintenant plus particulièrement aux figures 1 à 13 pour décrire un premier mode de mise en œuvre et de réalisation de l'invention.

Sur la figure 1, la référence PQ désigne une plaquette semiconductrice ou « wafer » en langue anglaise, comportant un substrat semiconducteur SB, par exemple en silicium, au niveau d'une face avant duquel ont été réalisés préalablement des composants, tels que des transistors T, de circuit intégré.

La face F1 ou face avant du substrat SB est recouverte d'une couche isolante 1, par exemple en oxyde de silicium ou en nitrure de silicium.

Le substrat SB possède également une deuxième face F2 ou face arrière, opposée à la première face.

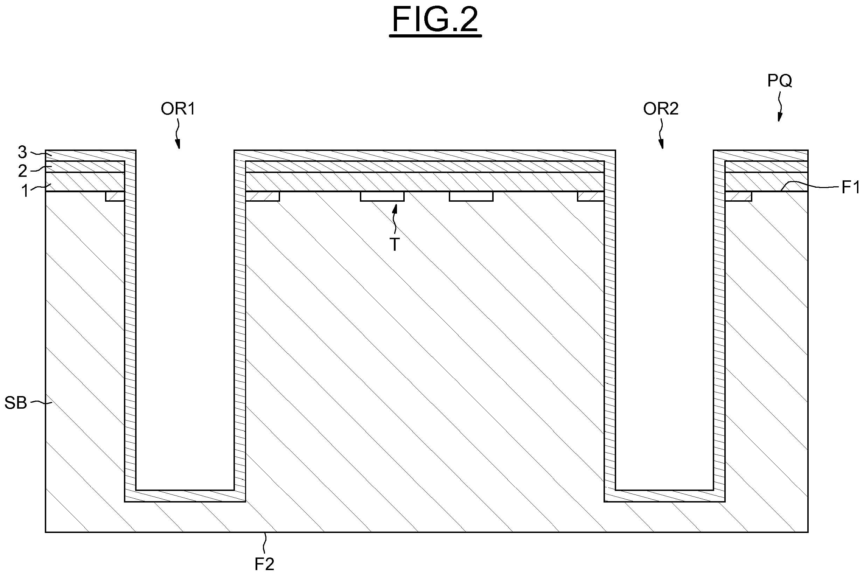

On dépose ensuite (figure 2) sur la couche 1 une couche 2 de masque dur que l'on grave par une opération classique de photolitographie en deux endroits de façon à définir les ouvertures de deux orifices borgnes OR1 et OR2.

Puis, on grave la couche 1 et le substrat SB de façon à former le premier orifice borgne OR1 et le deuxième orifice borgne OR2.

Bien entendu, ces orifices sont gravés à des endroits du substrat exempts de composant et/ou de circuit intégré.

Dans l'exemple décrit ici, les diamètres de ces deux orifices borgnes sont identiques, et par conséquent leur profondeur de gravure également.

A titre indicatif, le diamètre de chaque orifice borgne est de l'ordre de 10 microns, tandis que la profondeur de gravure est de l'ordre de 80 à 85 microns.

Puis, on dépose sur la structure et notamment sur les parois des orifices borgnes, une couche 3 de passivation, par exemple en dioxyde de silicium.

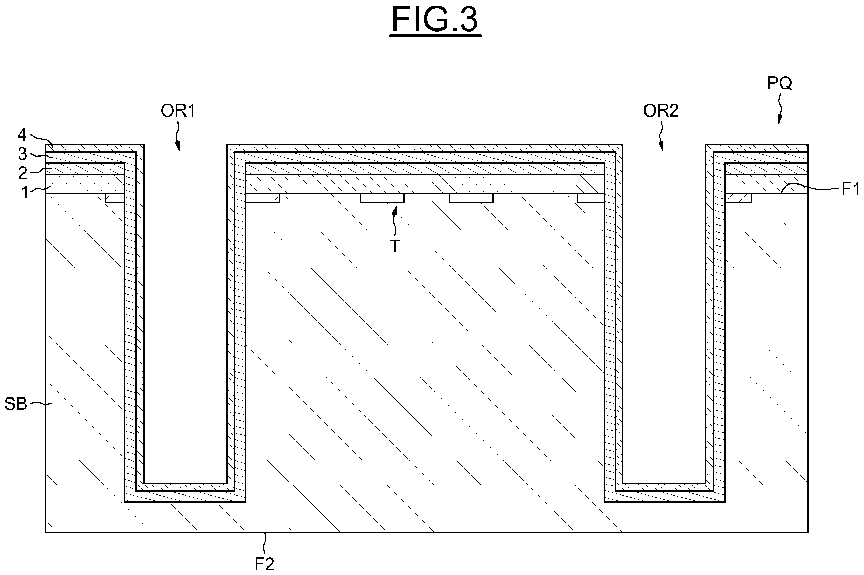

On dépose ensuite (figure 3) sur l'ensemble de la structure ainsi que sur les parois latérales et de fond des orifices borgnes OR1 et OR2, une première couche de germination 4 (« seed layer », en langue anglaise) par exemple du titane ou du tantale ou du nitrure de tantale.

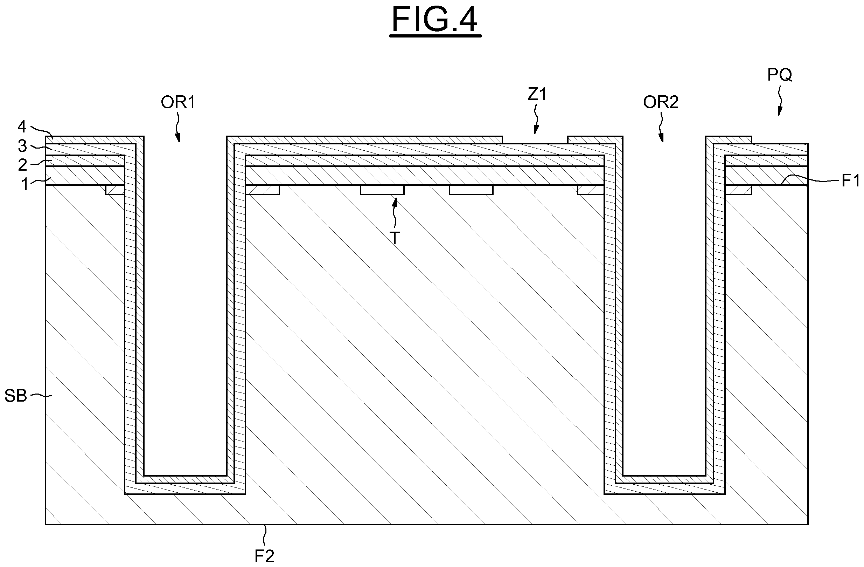

On procède ensuite (figure 4) à une gravure, typiquement une gravure chimique, de la couche de germination 4, en une zone Z1 située au dessus de la face F1 du substrat entre les deux orifices borgnes OR1 et OR2. Dans cet exemple, la zone Z1 est en fait une couronne annulaire autour du deuxième orifice borgne OR2.

En variante, il serait possible de ne déposer la couche de germination que dans l'orifice OR1 ou de retirer la couche de germination dans l'orifice OR2.

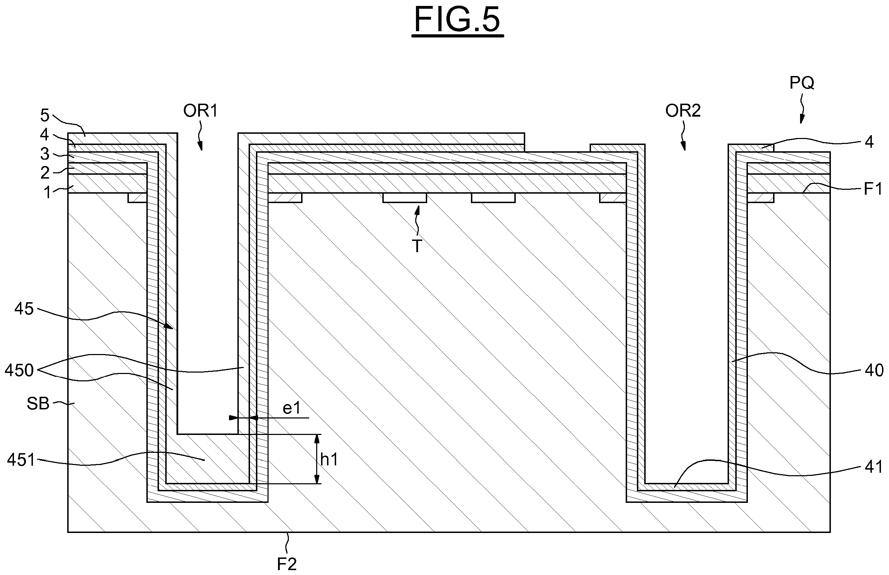

On procède ensuite à un remplissage partiel du premier orifice borgne OR1 avec une couche initiale 5 formée par électrolyse à partir de la couche de germination 4 (figure 5).

On remarque ici que la zone annulaire Z1 a permis d'isoler électriquement la couche de germination 4 située dans l'orifice OR2 de façon à ne pas former de couche 5 par électrolyse dans l'orifice OR2.

Cette couche 5 peut être par exemple du cuivre. Cette couche 5 va former, dans l'orifice OR1, une première région d'électrode 45 comportant une partie tubulaire (à savoir une partie déposée sur les parois verticales définissant l'orifice OR1) 450 raccordée à une portion de fond 451 ayant typiquement une hauteur hl typiquement de l'ordre de 10 à 15 microns.

La hauteur hl est donc supérieure à l'épaisseur el de la couche de cuivre déposée sur les parois latérales de l'orifice, cette épaisseur el étant par exemple de l'ordre de 1 micron, voire moins, pour hl de l'ordre de 10 microns.

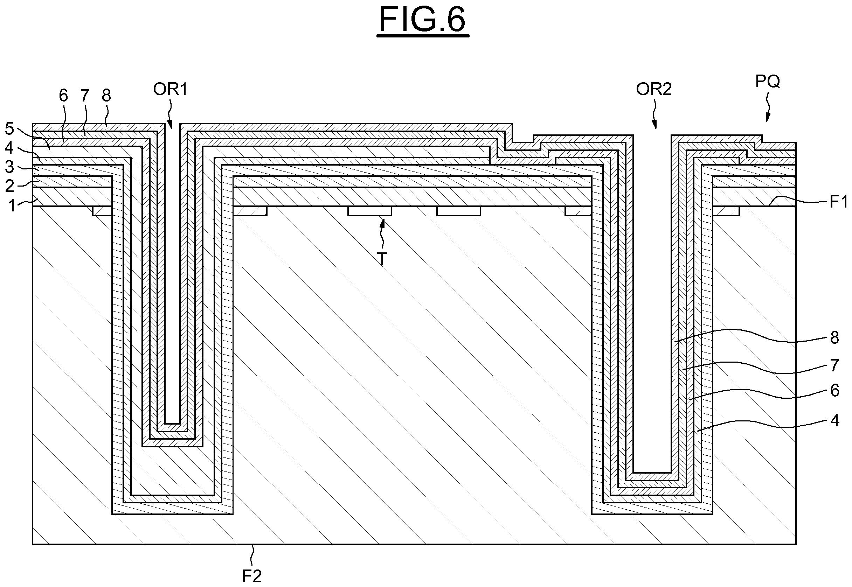

Puis, on dépose (figure 6) sur l'ensemble de la structure, et notamment dans les orifices OR1 et OR2, un empilement de trois couches comportant une couche barrière 6, par exemple en nitrure de titane, surmontée d'une couche diélectrique 7 composée d'un métal à fort coefficient diélectrique, par exemple du Ta₂O₅ ou de l'alumine, surmontée d'une autre couche barrière 8, également en nitrure de titane.

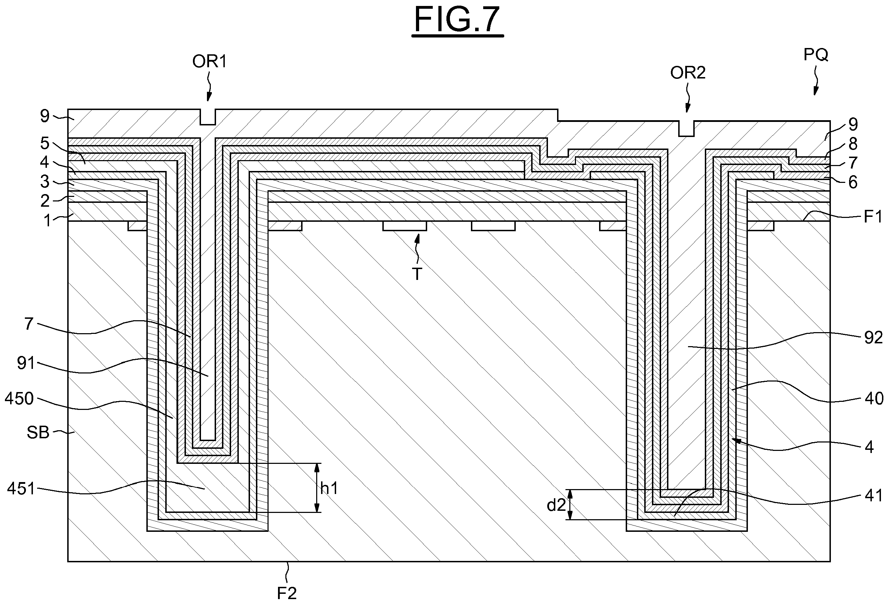

On dépose ensuite (figure 7) sur cet empilement une deuxième couche de germination, de composition analogue à la première couche de germination 4, sur laquelle on va déposer par électrolyse une couche globale électriquement conductrice 9, par exemple en cuivre. Cette couche globale 9 va combler les orifices borgnes OR1 et OR2 de façon à former dans l'orifice borgne OR1 une couche additionnelle 91 formant une deuxième région d'électrode et dans l'orifice borgne OR2 une couche additionnelle 92.

Il convient de noter ici que la couche barrière étant conductrice, elle contribue à la formation des deux électrodes du condensateur.

On notera ici que la hauteur hl de la portion de fond 451 de la première région d'électrode 45 est supérieure à la distance d2 séparant la couche 3 du deuxième orifice borgne OR2 de la couche additionnelle 92 contenue dans ce deuxième orifice borgne.

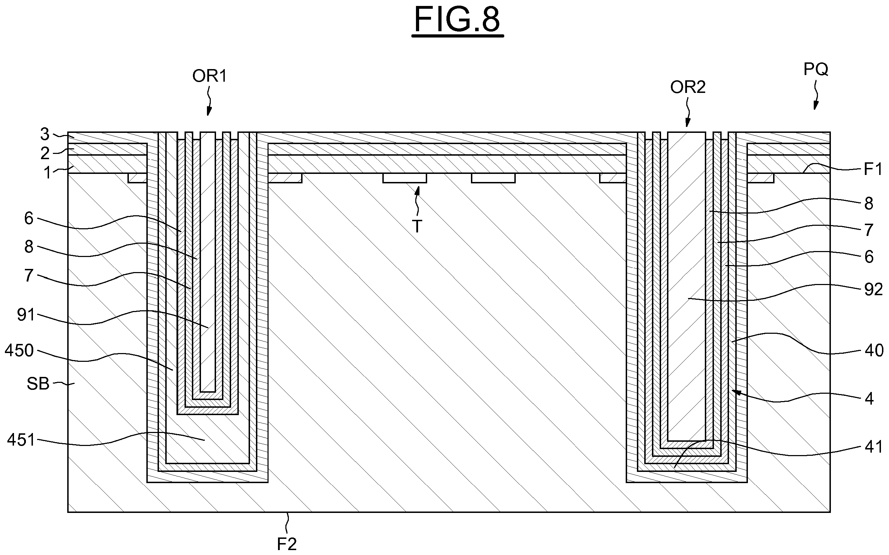

On procède ensuite (figure 8) à un retrait de la partie de l'empilement des couches 4 à 9 située au dessus de la face F1 du substrat. Ce retrait comporte par exemple un polissage mécanochimique et permet d'araser le contenu des orifices borgnes OR1, OR2.

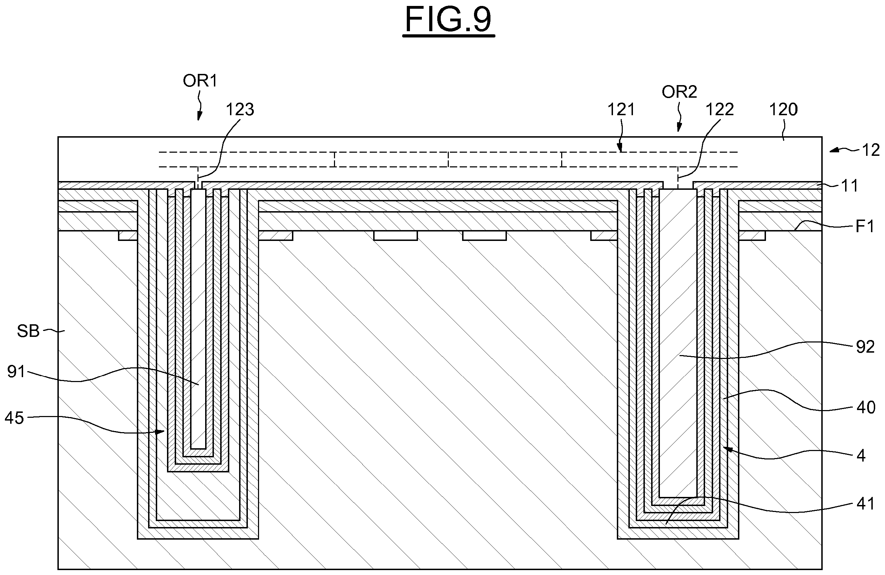

Puis, après avoir déposé une couche de passivation 11 (figure 9), par exemple en dioxyde de silicium ou un nitrure de silicium, on réalise de façon classique et connue en soi la partie d'interconnexion 12 (BEOL) de circuit intégré. Une telle partie d'interconnexion comprend de façon classique et connue en soi des niveaux de métallisation et des niveaux de vias encapsulés dans une région isolante 120. Les niveaux de métallisation comportent des pistes métalliques 121.

On voit ici que la couche de passivation permet notamment d'isoler la première région d'électrode 45 tandis qu'un via 123 connecte électriquement la deuxième région d'électrode 91 à la partie d'interconnexion 120. De même, un via 122 connecte la partie centrale conductrice 92 à la partie d'interconnexion 12.

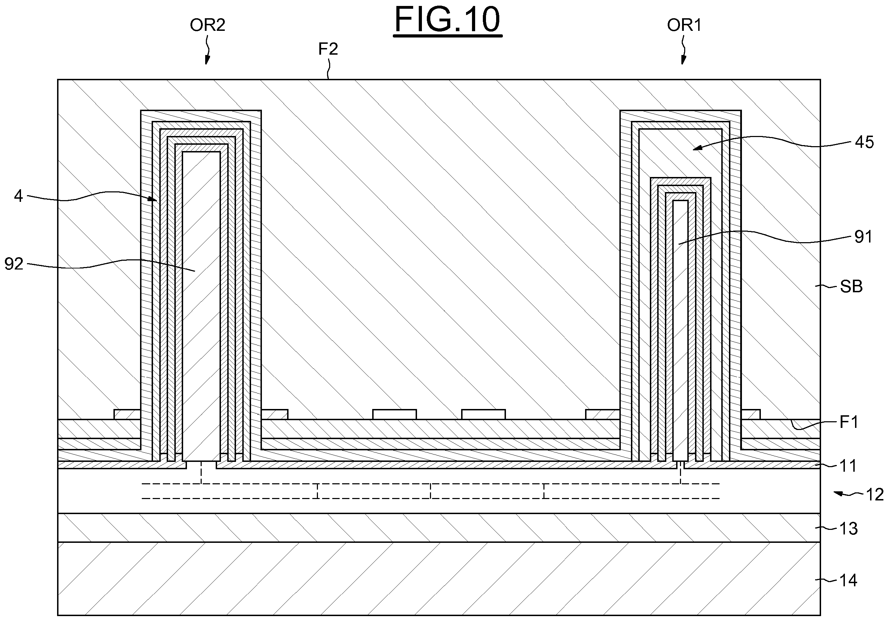

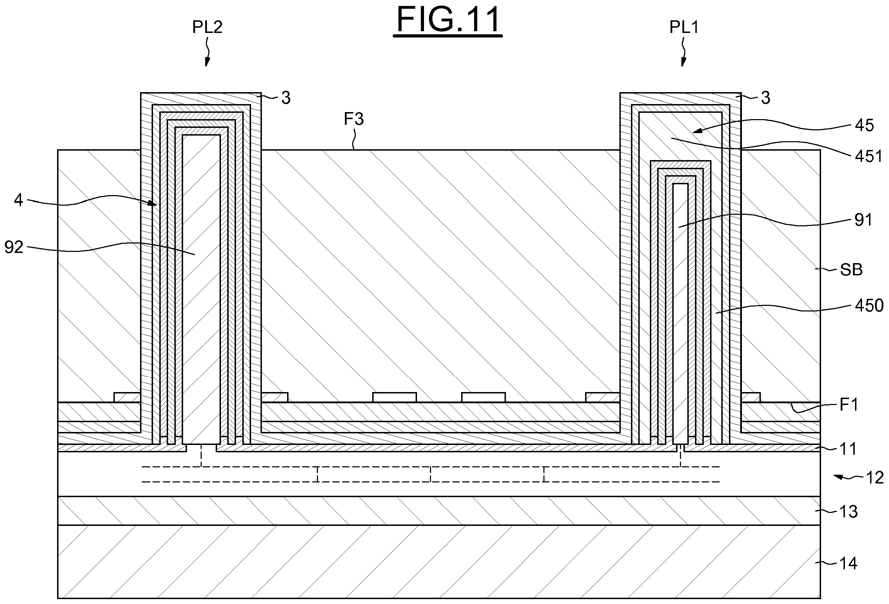

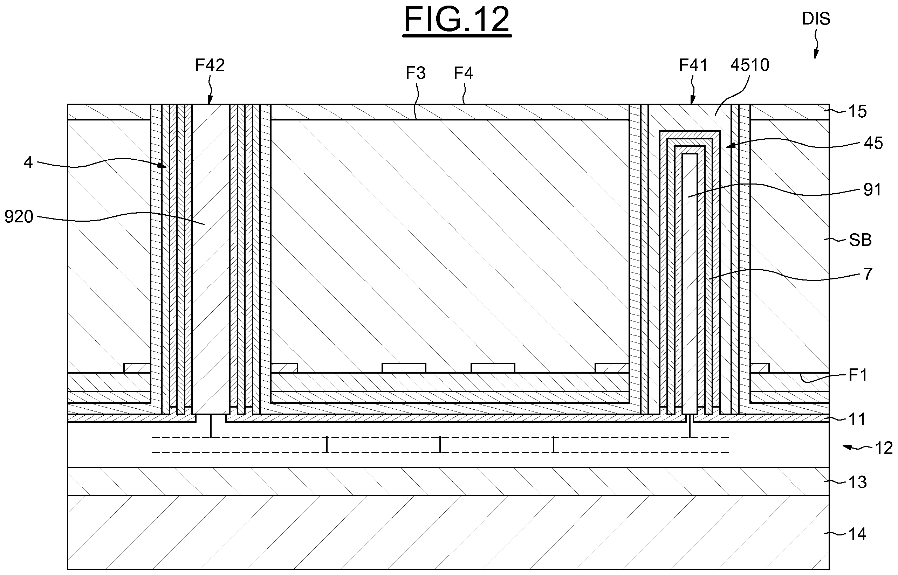

On procède ensuite (figure 10), à un collage temporaire d'un support 14 sur la partie d'interconnexion 12 au moyen d'une colle 13, ce qui va permettre d'effectuer un traitement de rabotage des orifices borgnes OR1, OR2 à partir de la deuxième face F2 du substrat SB comme cela va maintenant être décrit en référence aux figures 11 et 12.

Plus précisément, comme illustré sur la figure 11, on procède tout d'abord à un amincissement du substrat SB depuis la face arrière F2 suivi d'une gravure du silicium du substrat SB, sélective par rapport au matériau de la couche de passivation 3, de façon à obtenir une face arrière intermédiaire de substrat F3 de laquelle saillent les piliers PL1 et PL2 résultant de l'empilement de couches contenue dans les orifices borgnes OR1, OR2.

On dépose ensuite sur la face arrière de la structure de la figure 11, une couche d'un matériau 15, par exemple de l'oxynitrure de silicium SiON et l'on effectue une étape d'aplanissement de façon à obtenir une face arrière plane F4.

De par ce traitement de rabotage, la portion de fond 451 (figure 12) de la première région d'électrode 45 a été rabotée de même que la région centrale 92. Mais, compte tenu de la condition imposée sur les hauteurs hl et d2, il subsiste néanmoins toujours une portion de fond rabotée 4510 possédant une face de contact arrière F41 qui se situe dans le même plan que la face arrière de contact F42 de l'empilement de couches rabotées, (et notamment de la partie centrale rabotée 920) de la future liaison électrique.

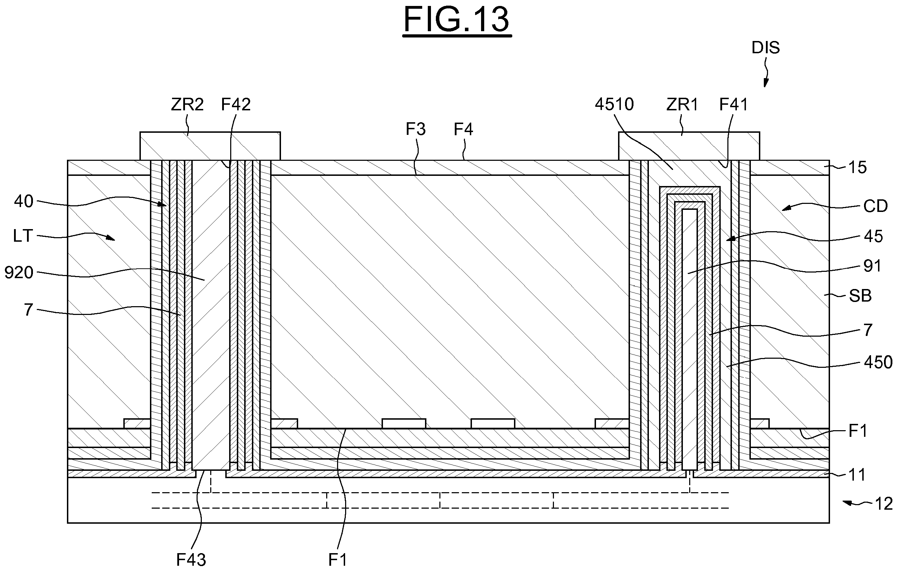

Le procédé se poursuit (figure 13) par la réalisation au dessus de la face plane F4 d'une première zone électriquement conductrice ZR1 en contact avec la première région d'électrode 45 et d'une deuxième zone électriquement conductrice ZR2 en contact avec la liaison électrique LT. Ces deux zones ZR1 et ZR2 peuvent par exemple faire partie d'une couche de redistribution.

On obtient donc un dispositif comprenant un substrat SB, une partie d'interconnexion de circuit intégré 12 disposée au dessus d'une première face F1 du substrat SB, un condensateur traversant CD possédant une première électrode 45 ayant une première face de contact F41 électriquement couplée à la première zone électriquement conductrice ZR1 disposée au dessus d'une deuxième face F3 (en l'espèce la face arrière) du substrat, et une deuxième électrode 91 électriquement couplée à la partie d'interconnexion 12.

Le dispositif comporte par ailleurs une liaison électriquement conductrice LT traversant le substrat ayant d'une part une première face de contact F42 électriquement couplée à la deuxième zone électriquement conductrice ZR2 disposée au dessus de la deuxième face F3 du substrat, et d'autre part, une partie F43 de la partie centrale 920 de la liaison LT, couplée à la partie d'interconnexion 12.

Et, les deux faces de contact F41 et F42 sont situées dans un même plan.

La première électrode 45 du condensateur comporte une partie tubulaire 450 (formée ici de cuivre et de nitrure de titane) raccordée à la portion de fond 4510 qui possède la première face de contact F41. Et, la deuxième électrode 91 (formée ici de cuivre et de nitrure de titane) est située à l'intérieur de la partie cylindrique de la première électrode et est séparée de celle-ci par une région diélectrique 7.

Quant à la liaison traversante LT, elle comporte la partie centrale électriquement conductrice 920 dont une première extrémité fait partie de la première face de contact F42 et dont une deuxième extrémité F43 est connectée à la partie d'interconnexion 12.

La liaison traversante comporte également une région diélectrique cylindrique 7 entourant la partie centrale et dont une première extrémité fait également partie de la première face de contact F42.

Dans ce mode de réalisation, la liaison traversante LT comporte en outre une partie périphérique cylindrique 40, résultant de la première couche de germination, entourant la partie centrale 920 et la région diélectrique 7, et dont une première extrémité fait également partie de la première face de contact F42.

Le dispositif DIS est généralement complété par des moyens de connexion électrique, par exemple des billes de soudure électriquement couplées aux zones ZR1 et ZR2 pour être soudées par exemple sur une carte de circuit imprimé. Par ailleurs, des plots de contact (« pads ») peuvent être réalisés sur la face avant de la partie d'interconnexion 12 de façon à supporter des piliers électriquement conducteurs destinés par exemple à être connectés à une autre puce de façon à former une structure intégrée tridimensionnelle. Le dispositif DIS est obtenu par découpe de la plaquette PQ selon des lignes de découpe.

Bien entendu, d'une manière générale, le dispositif DIS peut comporter plusieurs condensateurs traversants et plusieurs liaisons électriques traversantes qui sont réalisés simultanément comme décrit précédemment. On peut ainsi réaliser des condensateurs traversants de grandes dimensions dont les électrodes présentent de grandes surfaces de connexion électrique et peuvent aisément être connectées selon de nombreuses configurations, tout en atteignant des résistances faibles des connexions électriques. On obtient ainsi de densités élevées d'intégration.

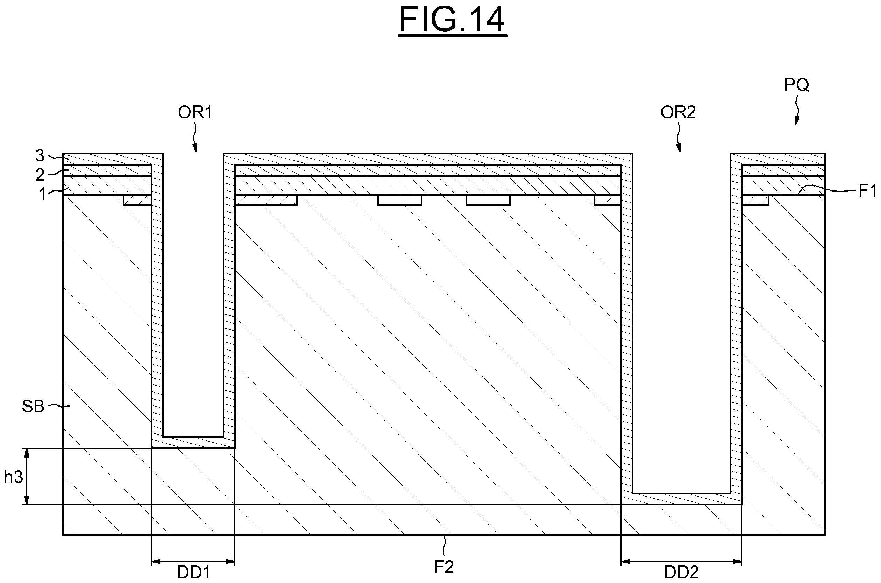

Dans le mode de mise en œuvre et de réalisation illustré sur les figures 14 à 18, ne faisant pas partie de la présente invention, les orifices borgnes OR1, OR2 n'ont cette fois-ci pas le même diamètre. On ne décrira maintenant que les différences entre ces modes de mise en œuvre et de réalisation et ceux qui viennent d'être décrits en référence aux figures 1 à 13.

On voit sur la figure 14 que le diamètre DD1 de l'orifice borgne OR1 destiné à recevoir le condensateur traversant est plus petit que le diamètre DD2 de l'orifice borgne OR2 destiné à recevoir la liaison traversante. Il en résulte donc une profondeur plus faible pour l'orifice OR1 que pour l'orifice OR2. A titre indicatif, si les diamètres DD1 et DD2 sont de l'ordre de 10 microns et 12 microns respectivement le dénivelé de profondeur h3 peut être compris entre 7 et 10 microns en fonction du procédé de gravure et du taux d'ouverture notamment.

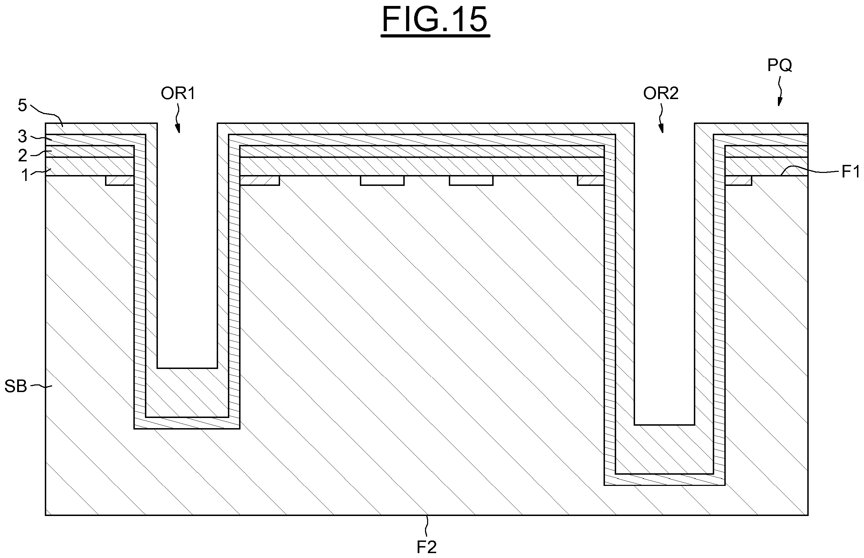

On procède ensuite (figure 15) au remplissage partiel des orifices OR1, OR2 en déposant par électrolyse la couche initiale 5 à partir de la première couche de germination qui cette fois-ci s'étend continûment sur l'ensemble de la structure.

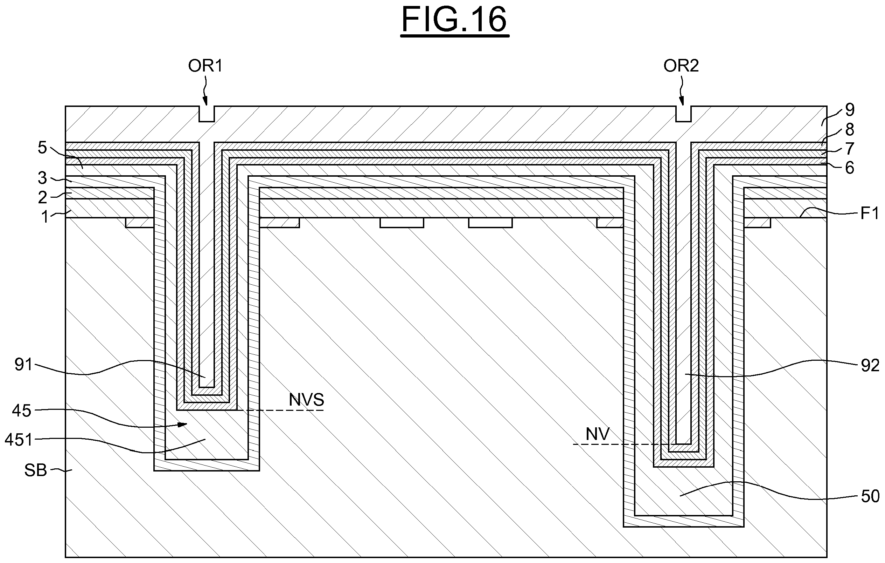

On forme ensuite (figure 16) d'une façon analogue à ce qui a été décrit ci-avant dans le mode de mise en œuvre précédent, l'empilement de couches 6, 7, 8, 9 de façon à combler les orifices OR1, OR2. A cet égard, les différentes profondeurs ainsi que les hauteurs de couches 50 et 451 déposées dans le fond des orifices OR1, OR2 ont été choisies de façon à ce que, comme illustré sur la figure 16, l'extrémité inférieure de la couche additionnelle 92 située dans le deuxième orifice borgne OR2 se situe à un niveau de profondeur NV situé en dessous du niveau supérieur NVS de la portion de fond 451 de la première région d'électrode 45.

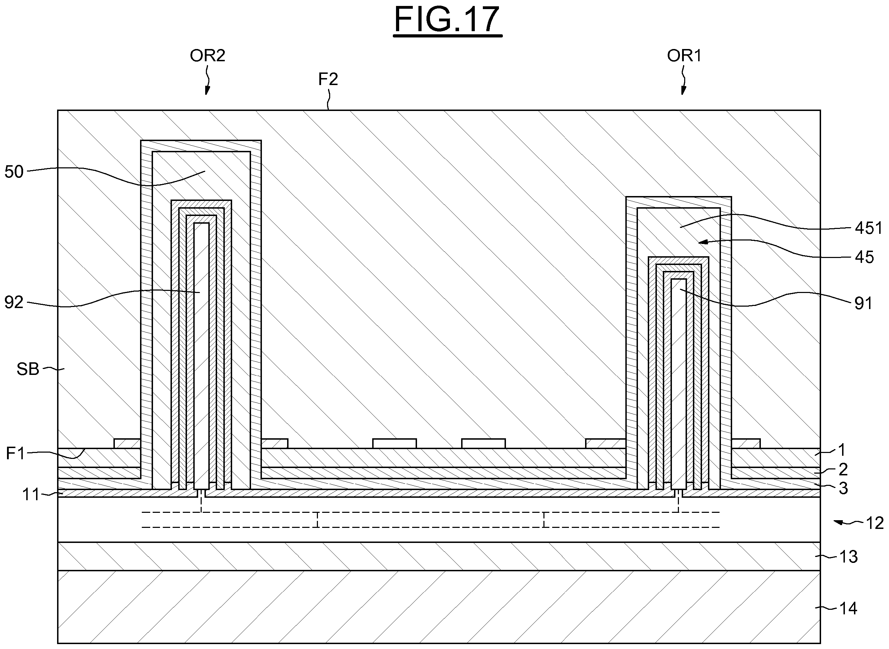

On procède ensuite (figure 17) d'une façon analogue à ce qui a été décrit ci-avant, au retrait de l'empilement au dessus de la structure, à la formation de la partie d'interconnexion 12 et au collage temporaire de la poignée de maintien 14 au moyen de la colle 13.

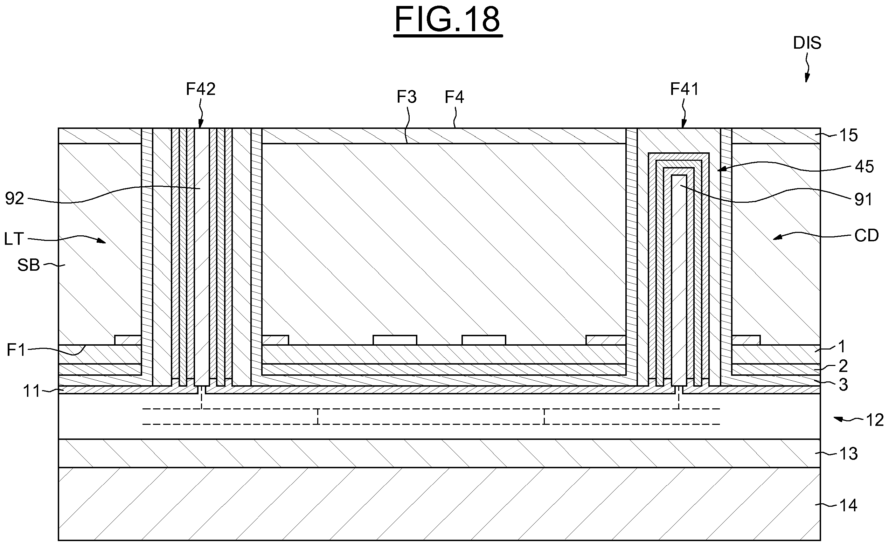

Puis, d'une façon analogue à ce qui a été décrit ci-avant, on procède (figure 18) au traitement de rabotage des orifices OR1, OR2 de façon à obtenir une structure de dispositif DIS analogue à celle illustrée sur la figure 12. Là encore, les faces de contact F41, F42 sont situées dans un même plan et ceci a été rendu possible grâce à la relation décrite ci-avant entre les niveaux NV et NVS.

Après réalisation des zones ZR1, ZR2 on obtient une structure analogue à celle de la figure 13.

En variante, il serait possible de ne pas déposer de couche de cuivre 5 au fond de l'orifice OR2.

## Revendications

1. Procédé de réalisation d'au moins une liaison électrique traversante et d'au moins un condensateur traversant dans un substrat, comprenant :
- une formation dans le substrat (SB) depuis une première face (F1) d'au moins un premier orifice borgne (OR1) destiné à la formation du condensateur et d'au moins un deuxième orifice borgne (OR2) destiné à la formation de la liaison électrique traversante,
- une formation d'une première région d'électrode (45) dudit condensateur au moins sur les parois latérales et sur la paroi de fond du premier orifice borgne (OR1), ladite formation de la première région d'électrode comportant une formation d'une couche initiale électriquement conductrice (5) dans le premier orifice borgne (OR1) par électrolyse à partir d'une première couche de germination électriquement conductrice (4),
- un remplissage du premier orifice borgne (OR1) et du deuxième orifice borgne (OR2) par la formation dans le premier orifice d'un empilement comportant au moins une couche diélectrique (7) et une couche additionnelle électriquement conductrice (91) au dessus de ladite couche diélectrique, la couche additionnelle (91) formant une deuxième région d'électrode dudit condensateur et par la formation dans le deuxième orifice d'un empilement comportant au moins la couche additionnelle (92) pour former au moins une partie de ladite liaison électrique,
- un amincissement du substrat à partir d'une deuxième face (F2) jusqu'à dévoiler les premier et second orifices borgnes et atteindre la première région d'électrode dans le premier orifice et atteindre ladite couche additionnelle dans le second orifice pour former la liaison électrique traversante, ladite couche initiale électriquement conductrice n'étant pas présente dans le fond du deuxième orifice (OR2) après ledit amincissement, et
- une réalisation d'une première zone électriquement conductrice (ZR1) en contact avec ladite première région d'électrode et d'une deuxième zone électriquement conductrice (ZR2) en contact avec ladite liaison électrique traversante,
dans lequel les orifices borgnes (OR1, OR2) ont la même profondeur, et la hauteur (h1) de la portion de fond de la première région d'électrode est supérieure à la distance (d2) séparant la paroi de fond du deuxième orifice borgne de ladite couche additionnelle contenue dans ce deuxième orifice borgne.

2. Procédé selon la revendication 1, dans lequel la couche additionnelle électriquement conductrice présente dans le premier orifice (OR1) et la couche additionnelle électriquement conductrice présente dans le deuxième orifice (OR2) sont obtenues par la formation d'une même couche globale électriquement conductrice (9).

3. Procédé selon la revendication 1 ou 2, dans lequel l'amincissement du substrat comprend une formation d'une face plane (F4) sur laquelle débouchent à la fois au moins une partie de ladite couche additionnelle située dans le premier orifice borgne et une partie de la portion de fond de la première région d'électrode, et la première zone électriquement conductrice (ZR1) en contact avec ladite première région d'électrode et la deuxième zone électriquement conductrice (ZR2) en contact avec ladite liaison électrique traversante sont réalisées au dessus de ladite face plane (F4).

4. Procédé selon la revendication 1, 2 ou 3, comportant en outre une formation au dessus de ladite première face d'une partie d'interconnexion (12) de circuit intégré en contact avec lesdites couches additionnelles du premier et du second orifice,

5. Procédé selon l'une des revendications précédentes, comprenant un dépôt de ladite première couche de germination (4) dans chacun des orifices borgnes et au dessus de la première face du substrat, et une gravure de cette première couche de germination dans une zone située au dessus de la première face du substrat entre les deux orifices bornes.

6. Procédé selon l'une des revendications précédentes, dans lequel le remplissage des orifices borgnes comprend une formation dudit empilement de couches (6, 7, 8, 9) également au dessus de la première face du substrat, et un retrait dudit empilement de couches situé au dessus de la première face du substrat.

7. Procédé selon la revendication 6, dans lequel la formation dudit empilement de couches comprend une formation de la couche globale électriquement conductrice (9) par électrolyse à partir d'une deuxième couche de germination, les portions (91, 92) de ladite couche globale situées dans les orifices formant respectivement lesdites couches additionnelles.

## Patentansprüche

1. Verfahren zur Herstellung mindestens einer Substratdurchkontaktierung und mindestens eines durchgehenden Kondensators in einem Substrat, umfassend:
- eine Bildung, in dem Substrat (SB) ab einer ersten Fläche (F1), mindestens eines ersten Sacklochs (OR1), das zur Bildung des Kondensators bestimmt ist und mindestens eines zweiten Sacklochs (OR2), das zur Bildung der Substratdurchkontaktierung bestimmt ist,
- eine Bildung einer ersten Elektrodenregion (45) des Kondensators mindestens auf den Seitenwänden und auf der Bodenwand des ersten Sacklochs (OR1), wobei die Bildung der ersten Elektrodenregion eine Bildung einer durchkontaktierenden Anfangsschicht (5) im ersten Sackloch (OR1) aufweist, durch Elektrolyse ab einer ersten durchkontaktierenden Keimschicht (4),
- ein Füllen des ersten Sacklochs (OR1) und des zweiten Sacklochs (OR2) durch die Bildung, im ersten Loch, eines Stapels, der mindestens eine dielektrische Schicht (7) und eine zusätzliche durchkontaktierende Schicht (91) über der dielektrischen Schicht aufweist, wobei die zusätzliche Schicht (91) eine zweite Elektrodenregion des Kondensators bildet, und durch die Bildung, im zweiten Loch, eines Stapels, der mindestens die zusätzliche Schicht (92) aufweist, um mindestens einen Teil der Kontaktierung zu bilden,
- eine Verschlankung des Substrats ab einer zweiten Fläche (F2) bis zur Freigabe des ersten und zweiten Sacklochs und Erreichung der ersten Elektrodenregion im ersten Loch und Erreichung der zusätzlichen Schicht im zweiten Loch, um die Substratdurchkontaktierung zu bilden, wobei die durchkontaktierende Anfangsschicht nach der Verschlankung nicht im Boden des zweiten Lochs (OR2) vorhanden ist, und
- eine Herstellung einer ersten durchkontaktierenden Zone (ZR1) im Kontakt mit der ersten Elektrodenregion und einer zweiten durchkontaktierenden Zone (ZR2) im Kontakt mit der Substratdurchkontaktierung,
wobei die Sacklöcher (OR1, OR2) dieselbe Tiefe haben und die Höhe (h1) des Bodenabschnitts der ersten Elektrodenregion größer als der Abstand (d2) ist, der die Bodenwand des zweiten Sacklochs von der zusätzlichen Schicht trennt, die in diesem zweiten Sackloch vorhanden ist.

2. Verfahren nach Anspruch 1, wobei die zusätzliche durchkontaktierende Schicht, die im ersten Loch (OR1) vorhanden ist, und die zusätzliche durchkontaktierende Schicht, die im zweiten Loch (OR2) vorhanden ist, durch Bildung derselben globalen durchkontaktierenden Schicht (9) erhalten werden.

3. Verfahren nach Anspruch 1 oder 2, wobei die Verschlankung des Substrats eine Bildung einer ebenen Fläche (F4) umfasst, auf der sowohl mindestens ein Teil der zusätzlichen Schicht, die sich im ersten Sackloch befindet, und ein Teil des Bodenabschnitts der ersten Elektrodenregion ausmünden, und die erste durchkontaktierende Zone (ZR1) im Kontakt mit der ersten Elektrodenregion und die zweite durchkontaktierende Zone (ZR2) im Kontakt mi der Substratdurchkontaktierung über der ebenen Fläche (F4) hergestellt sind.

4. Verfahren nach Anspruch 1, 2 oder 3, das ferner eine Bildung, über der ersten Fläche, eines Zusammenschaltungsteils (12) eines integrierten Schaltkreises im Kontakt mit den zusätzlichen Schichten des ersten und des zweiten Lochs aufweist.

5. Verfahren nach einem der vorangehenden Ansprüche, umfassend ein Aufbringen der ersten Keimschicht (4) in jedem der Sacklöcher und auf die erste Fläche des Substrats und eine Gravur dieser ersten Keimschicht in einer Zone, die sich über der ersten Fläche des Substrats zwischen den zwei Sacklöchern befindet.

6. Verfahren nach einem der vorangehenden Ansprüche, wobei das Füllen der Sacklöcher eine Bildung des Stapels der Schichten (6, 7, 8, 9) ebenfalls über der ersten Fläche des Substrats und ein Entfernen des Schichtstapels umfasst, der sich über der ersten Fläche des Substrats befindet.

7. Verfahren nach Anspruch 6, wobei die Bildung des Schichtstapels eine Bildung der globalen durchkontaktierenden Schicht (9) durch Elektrolyse ab einer zweiten Keimschicht umfasst, wobei die Abschnitte (91, 92) der globalen Schicht, die sich in den Löchern befinden, jeweils die zusätzlichen Schichten bilden.

## Claims

1. Method for producing at least one through electrical connection and at least one through capacitor in a substrate, comprising:
- forming in the substrate (SB) from a first face (F1) at least one first blind orifice (OR1) intended for forming the capacitor and at least one second blind orifice (OR2) intended for forming the through electrical connection,
- forming a first electrode region (45) of said capacitor at least on the side walls and on the bottom wall of the first blind orifice (OR1), said forming of the first electrode region including forming an initial electrically conductive layer (5) in the first blind orifice (OR1) by electrolysis using an electrically conductive seed layer (4),
- filling the first blind orifice (OR1) and the second blind orifice (OR2) by forming in the first orifice a stack including at least one dielectric layer (7) and an additional electrically conductive layer (91) on top of said dielectric layer, the additional layer (91) forming a second electrode region of said capacitor and by forming in the second orifice a stack including at least the additional layer (92) in order to form at least a part of said electrical connection,
- thinning the substrate from a second face (F2) until the first and second blind orifices are exposed and the first electrode region in the first orifice is reached and said additional layer in the second orifice is reached to form the through electrical connection, said electrically conductive initial layer not being present in the bottom of the second orifice (OR2) after said thinning, and
- producing a first electrically conductive zone (ZR1) in contact with said first electrode region and a second electrically conductive zone (ZR2) in contact with said through electrical connection,
wherein the blind orifices (OR1, OR2) have the same depth and the height (h1) of the bottom portion of the first electrode region is greater than the distance (d2) separating the bottom wall of the second blind orifice from said additional layer contained in this second blind orifice.

2. Method according to claim 1, wherein the additional electrically conductive layer present in the first orifice (OR1) and the additional electrically conductive layer present in the second orifice (OR2) are obtained by forming a single overall electrically conductive layer (9).

3. Method according to claim 1 or 2, wherein thinning the substrate comprises forming a planar face (F4) onto which both at least a part of said additional layer located in the first blind orifice and a part of the bottom portion of the first electrode region open, and the first electrically conductive zone (ZR1) in contact with said first electrode region and the second electrically conductive zone (ZR2) in contact with said through electrical connection are produced on top of said planar face.

4. Method according to claim 1, 2 or 3, further including forming on top of said first face an integrated circuit interconnection part (12) in contact with said additional layers of the first and second orifice.

5. Method according to one of the preceding claims, comprising depositing said first seed layer (4) in each of the blind orifices and on top of the first face of the substrate, and etching this first seed layer in a zone located on top of the first face of the substrate between the two blind orifices.

6. Method according to one of the preceding claims, wherein filling the blind orifices comprises forming said stack of layers (6, 7, 8, 9) also on top of the first face of the substrate, and removing said stack of layers located on top of the first face of the substrate.

7. Method according to claim 6, wherein forming said stack of layers comprises forming the electrically conductive overall layer (9) by electrolysis from a second seed layer, the portions (91, 92) of said overall layer located in the orifices forming respectively said additional layers.
